# EUROPÄISCHE PATENTANMELDUNG

(11) **EP 2 001 060 A2**
(43) Veröffentlichungstag der Anmeldung: **10.12.2008**
(21) Anmeldenummer: 08157889.0
(22) Anmeldetag: 09.06.2008
(51) Int. Cl.: H01L 33/00

(54) **Optoelektronisches Bauelement**

(30) Priorität: 08.06.2007 DE 102007026539; 11.07.2007 DE 102007032280
(71) Anmelder: OSRAM Opto Semiconductors GmbH, 93055 Regensburg (DE)
(72) Erfinder: Krummacher, Benjamin Claus, 93057 Regensburg (DE); Schindler, Florian, 83278 Traunstein (DE); von Malm, Norwin, 93186 Pettendorf (DE); Url, Manfred, 90419 Nürnberg (DE)
(74) Vertreter: Epping - Hermann - Fischer

(57) **Zusammenfassung**

Ein optoelektronisches Bauelement umfasst insbesondere eine erste Elektrode (3), eine strahlungsemittierende Schichtenfolge (1) mit einem aktiven Bereich (10) auf der ersten Elektrode (3), der eine Haupterstreckungsebene (E) mit einer Flächennormalen (N) aufweist und eine elektromagnetische Primärstrahlung mit einer nicht-Lambert'schen Abstrahlcharakteristik emittiert, eine zweite für die Primärstrahlung transparente Elektrode (4) auf der strahlungsemittierenden Schichtenfolge (1), und eine Wellenlängenkonversionsschicht (2) im Strahlengang der Primärstrahlung, die die Primärstrahlung zumindest zum Teil in eine elektromagnetische Sekundärstrahlung konvertiert. Dabei ist die erste Elektrode (3) reflektierend für die Primärstrahlung, während die nicht-Lambert'sche Abstrahlcharakteristik gegeben ist durch eine Intensität I(α) der Primärstrahlung der strahlungsemittierenden Schichtenfolge (1) in Abhängigkeit von einem zur Flächennormalen (N) gemessenen Abstrahlwinkel α, die Intensität I(α) von α ≥ 0° mit zunehmenden Winkel α bis zu einem Maximalwinkel αₘₐₓ hin zunimmt und die Konversionswahrscheinlichkeit der elektromagnetischen Primärstrahlung in der Wellenlängenkonversionsschicht (2) mit steigendem Abstrahlwinkel α zunimmt.

## Beschreibung

Diese Patentanmeldung beansprucht die Priorität der deutschen Patentanmeldungen 102007026539.7 und 102007032280.3, deren Offenbarungsgehalt hiermit durch Rückbezug aufgenommen wird.

Es wird ein optoelektronisches Bauelement nach dem Oberbegriff des Anspruchs 1 angegeben.

Zumindest eine Aufgabe von bestimmten Ausführungsformen ist es, ein optoelektronisches Bauelement mit einem aktiven Bereich anzugeben, das weiterhin eine Wellenlängenkonversionsschicht aufweist.

Diese Aufgabe wird durch einen Gegenstand mit den Merkmalen des unabhängigen Patentanspruchs 1 gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor.

Ein optoelektronisches Bauelement gemäß zumindest einer Ausführungsform umfasst insbesondere
- eine erste Elektrode,
- eine strahlungsemittierende Schichtenfolge mit einem aktiven Bereich auf der ersten Elektrode, der eine Haupterstreckungsebene mit einer Flächennormalen aufweist und eine elektromagnetische Primärstrahlung mit einer nicht-Lambert'schen Abstrahlcharakteristik emittiert,
- eine zweite für die Primärstrahlung transparente Elektrode auf der strahlungsemittierenden Schichtenfolge, und
- eine Wellenlängenkonversionsschicht im Strahlengang der Primärstrahlung, die die Primärstrahlung zumindest zum Teil in eine elektromagnetische Sekundärstrahlung konvertiert,
wobei
- die erste Elektrode reflektierend für die Primärstrahlung ist,
- die nicht-Lambert'sche Abstrahlcharakteristik gegeben ist durch eine Intensität I(α) der Primärstrahlung der strahlungsemittierenden Schichtenfolge in Abhängigkeit von einem zur Flächennormalen gemessenen Abstrahlwinkel α,
- die Intensität I(α) für Winkel α mit αₘᵢₙ ≤ α ≤ αₘₐₓ mit 0° ≤ αₘᵢₙ < αₘₐₓ mit zunehmenden Winkel α vom Minimalwinkel αₘᵢₙ bis zum Maximalwinkel αₘₐₓ hin zunimmt und
- die Konversionswahrscheinlichkeit der elektromagnetischen Primärstrahlung in der Wellenlängenkonversionsschicht mit steigendem Abstrahlwinkel α zunimmt.

Die Intensität I(α) kann dabei insbesondere die winkelabhängige Intensitätsverteilung sein, mit der die Primärstrahlung in die Wellenlängenkonversionsschicht eintritt. Insbesondere kann ein Teil der Primärstrahlung die Wellenlängenkonversionsschicht unkonvertiert durchqueren und aus der Wellenlängenkonversionsschicht austreten und von dieser abgestrahlt werden. Weiterhin kann auch die elektromagnetische Sekundärstrahlung aus der Wellenlängenkonversionsschicht austreten und von dieser abgestrahlt werden. Für einen externen Beobachter kann daher ein mischfarbiger Leuchteindruck durch Überlagerung der elektromagnetischen Primärstrahlung und elektromagnetischen Sekundärstrahlung wahrgenommen werden. Der mischfarbige Leuchteindruck kann dabei von den relativen Anteilen der Primärstrahlung und Sekundärstrahlung zueinander abhängen. Der Helligkeitseindruck, also die Helligkeit des mischfarbigen Leuchteindrucks, kann weiterhin von den absoluten Intensitäten der Primärstrahlung und Sekundärstrahlung abhängen. Um einen homogenen und isotropen mischfarbigen Leuchteindruck bei einem Beobachter erwecken zu können, kann es erforderlich sein, dass unter jedem Abstrahlwinkel α das gleiche Verhältnis an Intensität der Primärstrahlung zur Intensität der Sekundärstrahlung wahrnehmbar ist.

Insbesondere kann die elektromagnetische Sekundärstrahlung isotrop von der Wellenlängenkonversionsschicht abgestrahlt werden. Das kann bedeuten, dass unabhängig vom Abstrahlwinkel α der in die Wellenlängenkonversionsschicht eintretenden Primärstrahlung die Wellenlängenkonversionsschicht die durch Konversion eines Teils der Primärstrahlung erzeugte Sekundärstrahlung unabhängig vom Winkel α wieder abstrahlen kann und damit die Intensität der Sekundärstrahlung, die von einem Beobachter wahrgenommen werden kann, nicht vom Winkel α abhängt.

Die Wahrscheinlichkeit jedoch, dass Primärstrahlung in der Wellenlängenkonversionsschicht in Sekundärstrahlung konvertiert wird, kann weiterhin proportional zur durchquerbaren Wegstrecke in der Wellenlängenkonversionsschicht sein. Dadurch, dass die maximal durchquerbare Wegstrecke der elektromagnetischen Primärstrahlung in der Wellenlängenkonversionsschicht mit steigendem Abstrahlwinkel α zunimmt, kann auch die Wahrscheinlichkeit, dass Primärstrahlung in Sekundärstrahlung konvertiert wird, mit steigendem Abstrahlwinkel α zunehmen. Je größer also der Abstrahlwinkel α ist, desto kleiner kann der relative Anteil der Primärstrahlung im Vergleich zur unter dem Winkel α in die Wellenlängenkonversionsschicht eintretenden Primärstrahlung sein, der unkonvertiert unter dem Winkel α wieder aus der Wellenlängenkonversionsschicht austritt. Beispielsweise kann die Wellenlängenkonversionsschicht flächig mit einer Dicke D ausgebildet und in einer Ebene parallel zur Hauptersteckungsrichtung der organischen Schichtenfolge sein und über der organischen Schichtenfolge im Strahlengang der Primärstrahlung angeordnet sein. Die Wahrscheinlichkeit für eine Konversion von Primärstrahlung in Sekundärstrahlung kann somit proportional zu D/cos α sein. Dadurch könnte sich abhängig vom Winkel α zur Flächennormalen der organischen Schichtenfolge ein inhomogener mischfarbiger Leuchteindruck ergeben. Insbesondere bei einer für Leuchtdioden üblichen Lambert'schen Abstrahlcharakteristik mit einer winkelabhängigen Intensitätsverteilung proportional zu cos α kann dies bedeuten, dass der Anteil an der aus der Wellenlängenkonversionsschicht austretenden unkonvertierten Primärstrahlung für kleine Winkel α größer ist als der Anteil für große Winkel α. Dadurch kann bei üblichen Leuchtdioden der Leuchteindruck abhängig vom Abstrahlwinkel α durch Abnahme des relativen Anteils der unkonvertierten Primärstrahlung im Vergleich zur Sekundärstrahlung variieren.

Dadurch jedoch, dass die Intensität I(α) der Primärstrahlung mit zunehmendem Winkel α ausgehend vom Minimalwinkel αₘᵢₙ ≥ 0 bis zu einem Maximalwinkel αₘₐₓ zunimmt, kann der vom Winkel α abhängigen Wahrscheinlichkeit für eine Konversion von Primärstrahlung in Sekundärstrahlung entgegengewirkt werden. Die Intensität I(α) kann dabei in dem Winkelbereich αₘᵢₙ ≤ α ≤ αₘₐₓ durch eine monoton steigende Funktion repräsentiert werden. Beispielsweise kann der Minimalwinkel der Abstrahlwinkel parallel zur Flächennormalen sein, also αₘᵢₙ = 0°

Dabei kann die Abstrahlcharakteristik der Primärstrahlung eine Intensität I(α) mit einer maximalen Intensität Iₘₐₓ für den Maximalwinkel αₘₐₓ aufweisen. Insbesondere kann die maximale Intensität Iₘₐₓ ein globales Maximum der Intensitätsfunktion I(α) für 0° ≤ α ≤ 90° darstellen, das bedeutet, dass in die Abstrahlrichtung αₘₐₓ die höchste winkelabhängige Intensität Iₘₐₓ abgestrahlt wird. Der Maximalwinkel αₘₐₓ kann dabei größer oder gleich 10° sein. Weiterhin kann der Maximalwinkel größer oder gleich 15° oder besonders bevorzugt größer oder gleich 20° sein. Weiterhin oder zusätzlich kann der Maximalwinkel kleiner oder gleich 60° oder bevorzugt kleiner oder gleich 65° oder besonders bevorzugt kleiner oder gleich 70° sein.

Die Abstrahlcharakteristik der Primärstrahlung kann für einen Winkel von α = 0°, also in einer Abstrahlrichtung parallel zur Flächennormalen zur Haupterstreckungsrichtung der strahlungsemittierenden Schichtenfolge, durch eine Intensität I₀ charakterisiert sein und für Winkel α im Bereich 0° ≤ α < 90° durch die Funktion I₀/cos α repräsentiert oder angenähert sein. Weiterhin kann die Intensität I(α) für Winkel mit 0° ≤ α ≤ β durch die Funktion I(α) = I₀ [1/cos α + A(α)] parametrisiert werden, wobei β kleiner oder gleich 15° oder bevorzugt kleiner oder gleich 30° oder besonders bevorzugt kleiner oder gleich 65° sein kann. Dabei kann A(α) Werte im Bereich -Q ≤ A(α) ≤ Q annehmen mit Q ≤ 0,8, bevorzugt mit Q ≤ 0,5 oder besonders bevorzugt mit Q ≤ 0,25. Das kann insbesondere bedeuten, dass I(α) von der Proportionalität zum Inversen von cos α um ±Q abweichen kann. Die von der strahlungsemittierenden Schichtenfolge abgestrahlte Intensität der Primärstrahlung kann damit für Winkel α mit 0° ≤ α ≤ β durch eine Funktion I(α) repräsentiert werden, deren Funktionswerte in einem Bereich mit der Breite 2Q um die Funktion I₀/cos α liegen können und von der Funktion I₀/cos α um kleiner oder gleich Q abweichen können, also |I(α) - I₀/cos α| ≤ Q·I₀. Dabei kann die Abstrahlcharakteristik eine maximale Intensität Iₘₐₓ für einen Winkel αₘₐₓ ≤ β aufweisen oder für einen Winkel αₘₐₓ > β.

Die erste Elektrode kann ein Material mit einem gegebenen Reflexionsgrad R und die strahlungsemittierende Schichtenfolge einen Brechungsindex n für die elektromagnetische Primärstrahlung aufweisen. Der Brechungsindex kann dabei über die strahlungsemittierende Schichtenfolge konstant sein oder zumindest in Teilbereichen, beispielsweise in verschiedenen funktionalen Schichten, konstant sein. Weiterhin kann der Brechungsindex n auch über die strahlungsemittierende Schichtenfolge variieren. Der aktive Bereich der strahlungsemittierenden Schichtenfolge kann eine Dicke d aufweisen und mit einem mittleren Abstand L von der ersten Elektrode beabstandet angeordnet sein. Der mittlere Abstand L bezeichnet dabei den über die Dicke d des aktiven Bereichs gemittelten Abstand zur ersten Elektrode. Dabei können die Parameter R, n, d und L derart gewählt sein, dass die strahlungsemittierende Schichtenfolge die oben beschriebene Abstrahlcharakteristik aufweist. Beispielsweise können der Reflexionsgrad R der ersten Elektrode und der Brechungsindex n der strahlungsemittierenden Schichtenfolge aufgrund der jeweiligen Materialwahl vorgegeben sein, so dass durch Wahl des mittleren Abstands L und der Dicke d des aktiven Bereichs die gewünschte Abstrahlcharakteristik ermöglicht werden kann. Alternativ dazu können die Abmessungen der strahlungsemittierenden Schichtenfolge und des aktiven Bereichs, also der mittlere Abstand L und die Dicke d, vorgegeben sein, beispielsweise durch den Aufbau oder das Herstellungsverfahren des optoelektronischen Bauelements, so dass durch Wahl des Materials für die reflektierende ersten Elektrode über deren Reflexionsgrad R die gewünschte Abstrahlcharakteristik ermöglicht werden kann.

Beispielsweise kann dazu der mittlere Abstand L in der Größenordnung der Wellenlänge der Primärstrahlung oder kleiner sein. Weist die Primärstrahlung eine spektrale Verteilung von mehreren Wellenlängen und/oder Wellenlängenbereichen auf, kann die Primärstrahlung dabei auch durch eine mittlere Wellenlänge charakterisiert werden und die Abmessungen der strahlungsemittierenden Schichtenfolge hier und im folgenden auf die mittlere Wellenlänge der Primärstrahlung bezogen sein. Weiterhin kann der mittlere Abstand auch kleiner oder gleich kleiner oder gleich der halben Wellenlänge der Primärstrahlung sein oder kleiner oder gleich einem Viertel der Wellenlänge der Primärstrahlung oder auch kleiner oder gleich einem Achtel der Wellenlänge der Primärstrahlung sein. Weiterhin oder zusätzlich kann der mittlere Abstand L größer oder gleich 1/20 der Wellenlänge der Primärstrahlung sein oder auch größer oder gleich 1/10. Das kann beispielsweise bedeuten, dass bei einer ultraviolett bis blauen mittleren Wellenlänge der Primärstrahlung der Abstand L zwischen etwa 15 nm und 200 nm, bevorzugt zwischen 30 nm und 100 nm und besonders bevorzugt zwischen 40 nm und 60 nm sein kann.

Ein solcher mittlerer Abstand L kann in Verbindung mit der reflektierenden ersten Elektrode die Ausbildung einer zumindest halbseitig reflektierenden Kavität in der strahlungsemittierenden Schichtenfolge bewirken. Ein vom einem angeregten Zustand (Exciton) im aktiven Bereich abgestrahltes Photon bzw. Wellenpaket kann dabei an der ersten Elektrode reflektiert werden. Dadurch, dass der mittlere Abstand L in der Größenordnung der Wellenlänge der Primärstrahlung oder kleiner sein kann, kann, vereinfacht gesprochen, eine Rückkopplung des abgestrahlten Wellenpakets mit dem angeregten Zustand noch während der Abstrahlung des Wellenpakets möglich sein, so dass der angeregte Zustand während der Abstrahlung des Wellenpakets vom elektromagnetischen Feld seines "eigenen" reflektierten Wellenpakets beeinflusst werden kann. Je nach Phasenlage des reflektierten Wellenpakets kann somit eine Verstärkung oder Abschwächung der Abstrahlung des angeregten Zustands ermöglicht werden. Die Phasenlage kann dabei vom Brechungsindex der strahlungsemittierenden Schichtenfolge, der Reflektivität der ersten Elektrode in Verbindung mit der Eindringtiefe der elektromagnetischen Strahlung in die erste Elektrode sowie von dem Abstand zwischen dem angeregten Zustand und der ersten Elektrode in Verbindung mit der Abstrahlrichtung des Wellenpakets abhängig sein. Dadurch kann sich in der strahlungsemittierenden Schichtenfolge eine Modenstruktur ausbilden, die eine Abstrahlung der Primärstrahlung zu größeren Abstrahlwinkeln α begünstigen und/oder bewirken kann.

Weiterhin kann die Dicke des aktiven Bereichs die Ausbildung von Abstrahlungsmoden beeinflussen. Insbesondere kann es dabei vorteilhaft sein, wenn die Dicke d des aktiven Bereichs kleiner als oder gleich 20 nm ist. Bevorzugt kann die Dicke d kleiner oder gleich 15 nm oder weiterhin kleiner oder gleich 10 nm sein. Darüber hinaus kann die Dicke d des aktiven Bereichs auch kleiner oder gleich 5 nm sein.

Dabei kann die strahlungsemittierende Schichtenfolge als organische, strahlungsemittierende Diode (OLED) beziehungsweise als organischen Schichtenfolge ausgeführt sein. Die organische Schichtenfolge bzw. die OLED kann beispielsweise eine ein Substrat aufweisen, wobei die erste Elektrode direkt auf dem Substrat angeordnet sein kann. Da die erste Elektrode reflektierend ausgeführt ist und die zweite Elektrode transparent, kann das bedeuten, dass die Primärstrahlung in eine Richtung vom Substrat weg abgestrahlt werden kann("top emitter"). Alternativ kann die zweite Elektrode direkt auf dem Substrat angeordnet sein, so dass die Primärstrahlung durch das Substrat hindurch abgestrahlt werden kann ("bottom emitter"). Über der ersten Elektrode kann ein funktionaler Bereich mit einer oder mehreren funktionalen Schichten aus organischen Materialien aufgebracht sein. Die funktionalen Schichten können dabei beispielsweise ein oder mehrere Elektroneninjektionsschichten ("electron injection layer", EIL), Elektronentransportschichten ("electron transport layer", ETL), Lochsperrschichten ("hole blocking layer", HIL,) elektrolumineszierende Schichten ("electroluminescent layer", EL), Elektronsperrschichten ("electron blocking layer", EBL), Lochtransportschichten ("hole transport layer", HTL) und/oder Lochinjektionsschichten ("hole injection layer", HIL) aufweisen. Einzelne Schichten können auch Funktionalitäten mehrerer der vorgenannten Schichten aufweisen. So kann eine Schicht beispielsweise als HIL und als HTL oder als EIL und als ETL dienen. Der aktive Bereich kann beispielsweise durch ein EL gebildet sein oder ein EL umfassen. Weiterhin kann der aktive Bereich beispielsweise auch im Bereich einer Grenzfläche zweier Schichten ausgebildet sein, etwa an der Grenzfläche zwischen einem ETL und einem HTL.

Beispielsweise kann das Substrat Glas, Quarz, Kunststofffolien, Metall, Metallfolien, Halbleiterwafer wie etwa Siliziumwafer oder eine Germaniumwafer oder Wafer basierend auf Phosphor- und/oder Stickstoff-haltigen Halbleitermaterialien oder ein beliebiges anderes geeignetes Substratmaterial umfassen. Ist die organische Schichtenfolge bzw. die OLED als so genannter "bottom emitter" ausgeführt, das heißt, das die im aktiven Bereich erzeugte Primärstrahlung durch das Substrat abgestrahlt wird, so kann das Substrat transparent für zumindest einen Teil der Primärstrahlung aufweisen.

Die erste Elektrode kann als Kathode ausgeführt sein und somit als Elektronen-induzierendes Material dienen. Als Kathodenmaterial können sich unter anderem insbesondere Aluminium, Barium, Indium, Silber, Gold, Magnesium, Kalzium oder Lithium sowie Verbindungen, Kombinationen und Legierungen davon als vorteilhaft erweisen.

Die transparente zweite Elektrode, die als Anode ausgeführt sein kann und somit als Löcher-induzierendes Material dienen kann, kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoff-verbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin kann es möglich sein, dass die TCOs nicht zwingend einer stöchiometrischen Zusammensetzung entsprechen und auch p- oder n-dotiert sein können. Alternativ oder zusätzlich kann die zweite Elektrode auch ein Metall, beispielsweise wie im Zusammenhang mit der ersten Elektrode genannt, aufweisen. Beispielsweise kann die zweite Elektrode eine Metallschicht umfassen, die zumindest teilweise transparent für die Primärstrahlung ist. Weiterhin kann die zweite Elektrode auch ein organisches elektrisch leitendes Material aufweisen.

Die funktionalen Schichten können organische Polymere, organische Oligomere, organische Monomere, organische kleine, nicht-polymere Moleküle ("small molecules") oder Kombinationen daraus aufweisen. Abhängig von den Materialien in den funktionellen Schichten kann die erzeugte erste Strahlung einzelne Wellenlängen oder Bereiche oder Kombinationen daraus aus dem ultravioletten bis rotem Spektralbereich aufweisen.

Weiterhin kann die OLED eine Verkapselung aufweisen, um für die Elektroden und den funktionalen Bereich einen Schutz vor Feuchtigkeit und/oder oxidierenden Substanzen wie etwa Sauerstoff zu erreichen. Dabei kann die Verkapselung die gesamte OLED einschließlich des Substrats umgeben. Alternativ kann das Substrat einen Teil der Verkapselung bilden. Die Verkapselung kann dabei eine oder mehrere Schichten umfassen, wobei die Schichten der Verkapselung beispielsweise Planarisierungsschichten, Barriereschichten, Wasser und/oder Sauerstoff absorbierende Schichten, Verbindungsschichten oder Kombinationen daraus sein können. Weiterhin kann die Verkapselung transparent ausgebildet sein, insbesondere bei einer als "top emitter" ausgebildeten organischen Schichtenfolge.

Weiterhin kann die strahlungsemittierende Schichtenfolge auch als anorganische Licht emittierende Diode (LED), also als anorganische Halbleiterschichtenfolge ausgeführt sein. Dabei kann die Halbleiterschichtenfolge als Epitaxieschichtenfolge, also als epitaktisch gewachsene Halbleiterschichtenfolge ausgeführt sein. Insbesondere kann die Halbleiterschichtenfolge beispielsweise auf der Basis eines anorganischen Materials, etwa InGaAlN, wie etwa als GaN-Dünnfilm-Halbleiterschichtenfolge, ausgeführt sein. Unter InGaAlN-basierte Halbleiterschichtenfolgen fallen insbesondere solche, bei denen die epitaktisch hergestellte Halbleiterschichtenfolge, die in der Regel eine Schichtenfolge aus unterschiedlichen Einzelschichten aufweist, mindestens eine Einzelschicht enthält, die ein Material aus dem III-V-Verbindungshalbleitermaterialsystem InₓAl_{y}Ga_{1-x-y}N mit 0 ≤ x ≤ 1, 0 ≤ y ≤ 1 und x+y ≤ 1 aufweist.

Alternativ oder zusätzlich kann die Halbleiterschichtenfolge auch auf InGaAlP basieren, das heißt, dass die Halbleiterschichtenfolge unterschiedliche Einzelschichten aufweist, wovon mindestens eine Einzelschicht ein Material aus dem III-V-Verbindungshalbleitermaterialsystem InₓAl_{y}Ga_{1-x-y}P mit 0 ≤ x ≤ 1, 0 ≤ y ≤ 1 und x+y ≤ 1 aufweist. Alternativ oder zusätzlich kann die Halbleiterschichtenfolge auch andere III-V-Verbindungshalbleitermaterialsysteme, beispielsweise ein AlGaAs-basiertes Material, oder II-VI-Verbindungshalbleitermaterialsysteme aufweisen.

Bei einer weiteren Ausführungsform ist die Halbleiterschichtenfolge eine strahlungsemittierende Dünnfilm-Halbleiterschichtenfolge verwendet werden. Weiterhin kann die strahlungsemittierende Halbleiterschichtenfolge oder die strahlungsemittierende Dünnfilm-Halbleiterschichtenfolge als Halbleiterleuchtdiode oder Dünnfilm-Halbleiterleuchtdiode ausgeführt sein. Eine strahlungsemittierende Dünnfilmschichtenfolge oder eine Dünnfilm-Halbleiterleuchtdiode zeichnen sich insbesondere durch folgende charakteristische Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf. Ein Grundprinzip einer Dünnschicht-Halbleiterleuchtdiode ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Hinsichtlich der weiteren Elemente der strahlungsemittierenden Schichtenfolge wie etwa dem substrat oder der Verkapselung sowie hinsichtlich der Elektroden können die in Verbindung mit der organischen Schichtenfolge genannten Materialien und Merkmale Anwendung finden.

Weiterhin kann die strahlungsemittierende Schichtenfolge auch Kombinationen aus den oben genannten organischen und anorganischen Schichten aufweisen.

Weiterhin kann die strahlungsemittierende Schichtenfolge statt als organische oder anorganische Diode auch als elektrolumineszierende Schichtenfolge für ein Elektrolumineszenz-Bauelement (ELB) ausgeführt sein, beispielsweise als Elektrolumineszenzfolie (ELF). Ein ELB kann einen aktiven Bereich mit anorganischen Materialien aufweisen, die beispielsweise auf Zinksulfid basieren, das in einem elektrisch isolierenden Material eingebettet oder zwischen elektrisch isolierenden Schichten angeordnet sein kann. Der aktive Bereich kann weiterhin eine geeignete Dotierung aufweisen, die beispielsweise Kupfer und/oder Europium umfassen kann. Eine elf kann Kunststofffolien aufweisen, zwischen denen die Elektroden und die elektrolumineszierende Schichtenfolge angeordnet sind und die als Substrat und/oder als Verkapselung ausgestaltet sein können.

Die Wellenlängenkonversionsschicht kann einen oder mehrere Wellenlängenkonversionsstoffe aufweisen, die geeignet sind, die elektromagnetische Primärstrahlung zumindest teilweise zu absorbieren und als Sekundärstrahlung mit einem zumindest teilweise von der Primärstrahlung verschiedenen Wellenlängenbereich zu emittieren. Die elektromagnetische Primärstrahlung und elektromagnetische Sekundärstrahlung können eine oder mehrere Wellenlängen und/oder Wellenlängenbereiche in einem infraroten bis ultravioletten Wellenlängenbereich umfassen, insbesondere in einem sichtbaren Wellenlängenbereich. Dabei kann das Spektrum der Primärstrahlung und/oder das Spektrum der Sekundärstrahlung schmalbandig sein, das heißt, dass die Primärstrahlung und/oder die Sekundärstrahlung einen einfarbigen oder annähernd einfarbigen Wellenlängenbereich aufweisen können. Das Spektrum der Primärstrahlung und/oder das Spektrum der Sekundärstrahlung kann alternativ auch breitbandig sein, das heißt, dass die Primärstrahlung und/oder die Sekundärstrahlung einen mischfarbigen Wellenlängenbereich aufweisen kann, wobei der mischfarbige Wellenlängenbereich ein kontinuierliches Spektrum oder mehrere diskrete spektrale Komponenten mit verschiedenen Wellenlängen aufweisen kann. Beispielsweise kann die elektromagnetische Primärstrahlung einen Wellenlängenbereich aus einem ultravioletten bis blauen Wellenlängenbereich aufweisen, während die elektromagnetische Sekundärstrahlung einen Wellenlängenbereich aus einem blauen bis roten Wellenlängenbereich aufweisen kann. Besonders bevorzugt können die Primärstrahlung und die Sekundärstrahlung überlagert einen weißfarbigen Leuchteindruck erwecken. Dazu kann die Primärstrahlung vorzugsweise einen blaufarbigen Leuchteindruck erwecken und die Sekundärstrahlung einen gelbfarbigen Leuchteindruck, der durch spektrale Komponenten der Sekundärstrahlung im gelben Wellenlängenbereich und/oder spektrale Komponenten im grünen und roten Wellenlängenbereich entstehen kann.

Der Wellenlängenkonversionsstoff kann dabei eines oder mehrere der folgenden Materialien aufweisen: Granate der Seltenen Erden und der Erdalkalimetalle, beispielsweise YAG:Ce³⁺, weiterhin auch Nitride, Nitridosilikate, Sione, Sialone, Aluminate, Oxide, Halophosphate, Orthosilikate, Sulfide, Vanadate, Perylene, Coumarin und Chlorosilikate. Weiterhin kann die Wellenlängenkonversionsschicht auch geeignete Mischungen und/oder Kombinationen umfassen, die beispielsweise die genannten Wellenlängenkonversionsstoffe aufweisen. Dadurch kann es beispielsweise möglich sein, dass wie oben beschrieben, die Wellenlängenkonversionsschicht in einem blauen ersten Wellenlängenbereich absorbiert und in einem zweiten Wellenlängenbereich emittiert, der grüne und rote Wellenlängen und/oder gelbe Wellenlängenbereiche aufweist.

Weiterhin kann die Wellenlängenkonversionsschicht ein transparentes Matrixmaterial umfassen, das den oder die Wellenlängenkonversionsstoffe umgibt oder enthält oder an die Wellenlängenkonversionsstoffe chemisch gebunden ist. Das transparente Matrixmaterial kann beispielsweise Silikone, Epoxide, Acrylate, Imide, Urethane, Carbonate, Olefine oder Derivate davon in Form von Monomeren, Oligomeren oder Polymeren als Mischungen, Copolymere oder Verbindungen damit aufweisen. Beispielsweise kann das Matrixmaterial ein Epoxidharz, Polymethylmethacrylat (PMMA) oder ein Silikonharz wie etwa Polydimethylsiloxan sein.

Der oder die Wellenlängenkonversionsstoffe können dabei homogen im Matrixmaterial verteilt sein. Alternativ dazu kann die Wellenlängenkonversionsschicht mehrere Wellenlängenkonversionsstoffe aufweisen, die in verschiedenen Schichten in der Wellenlängenkonversionsschicht angeordnet sind.

Die Wellenlängenkonversionsschicht kann weiterhin ein transparentes Trägersubstrat aufweisen, auf dem ein oder mehrere Wellenlängenkonversionsstoffe direkt aufgebracht sind oder auf dem ein Matrixmaterial mit einem oder mehreren Wellenlängenkonversionsstoffen aufgebracht ist. Als Substratmaterial können sich beispielsweise die oben im Zusammenhang mit dem Substrat für die strahlungsemittierende Schichtenfolge genannten Materialien eignen.

Die Wellenlängenkonversionsschicht kann weiterhin über ein Brechungsindex-anpassendes Material beziehungsweise ein optisch koppelndes Material, etwa ein Brechungsindex-anpassendes Gel oder Öl an die strahlungsemittierende Schichtenfolge optisch angekoppelt sein. Dazu kann beispielsweise bei einer als "bottom emitter" ausgeführten strahlungsemittierende Schichtenfolge, beispielsweise eine OLED oder LED in "bottom emitter"-Konfiguration, die Wellenlängenkonversionsschicht mittels eines optisches Gels an das Substrat der strahlungsemittierenden Schichtenfolge optisch angekoppelt sein. Alternativ dazu kann bei einer als "top emitter" ausgeführten strahlungsemittierenden Schichtenfolge die Wellenlängenkonversionsschicht auf der zweiten Elektrode oder auf einer Verkapselung mittels eine optischen Gels angeordnet sein.

Zwischen der strahlungsemittierenden Schichtenfolge und der Wellenlängenkonversionsschicht können, falls zweckmäßig, zusätzliche Schichten wie zum Beispiel Verbindungsschichten, Klebeschichten oder weitere funktionelle Schichten angeordnet sein.

Weitere Vorteile und vorteilhafte Ausführungsformen und Weiterbildungen der Erfindung ergeben sich aus den im Folgenden in Verbindung mit den Figuren 1 bis 5B beschriebenen Ausführungsformen.

Es zeigen:
- Figur 1: eine schematische Darstellung eines optoelektronischen Bauelements gemäß einem Ausführungsbeispiel,
- Figur 2: Graphen von Abstrahlcharakteristiken der Primärstrahlung,
- Figuren 3A und 3B: Simulationen für Abstrahlcharakteristiken und daraus resultierende winkelabhängige CIE-Farbortverteilungen für optoelektronische Bauelemente gemäß weiteren Ausführungsbeispielen,
- Figuren 4A und 4B: schematische Darstellungen optoelektronischer Bauelemente gemäß weiteren Ausführungsbeispielen,
- Figuren 5A und 5B: Graphen von Abstrahlcharakteristiken und daraus resultierenden winkelabhängigen CIE-Farbortverteilungen für optoelektronische Bauelemente gemäß weiterer Ausführungsbeispiele.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

In den folgenden Ausführungsbeispielen sind rein beispielhaft optoelektronische Bauelement lediglich mit organischen Schichtenfolgen beschrieben. Diese können auch durch anorganische Schichtenfolgen oder durch elektrolumineszierende Schichtenfolgen wie im allgemeinen Teil beschrieben ersetzt oder mit diesen kombiniert werden.

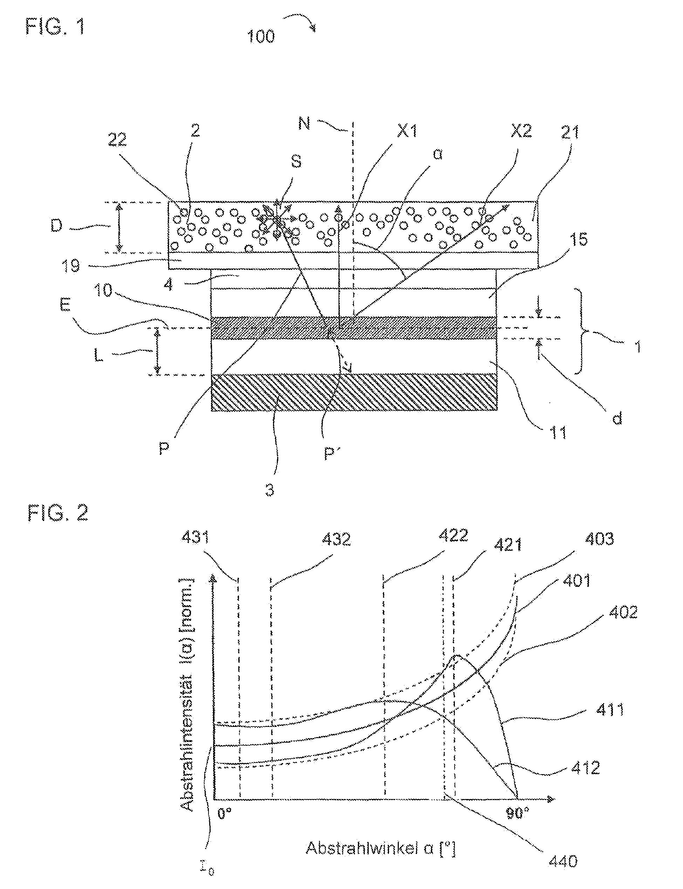

In Figur 1 ist ein Ausführungsbeispiel für ein optoelektronisches Bauelement 100 mit einer organischen Schichtenfolge 1 und einer Wellenlängenkonversionsschicht 2 gezeigt.

Die organische Schichtenfolge 1 weist einen aktiven Bereich 10 auf, der im Betrieb blaue elektromagnetische Primärstrahlung, beispielhaft durch den Pfeil P angedeutet, abstrahlen kann. Weiterhin umfasst die organische Schichtenfolge 1 funktionale Schichten 11 und 15, die beispielsweise als Elektronentransportschicht 11 und als Lochtransportschicht 15 wie im allgemeinen Teil der Beschreibung ausgeführt ausgebildet sind. Der aktive Bereich 10 ist dabei der Bereich, in dem injizierte Elektronen und Löcher aus den funktionalen Schichten 11 und 15 zur Erzeugung der elektromagnetischen Primärstrahlung rekombinieren können. Die organische Schichtenfolge 1 ist auf einer ersten Elektrode 3 angeordnet, die reflektierend für die Primärstrahlung ausgeführt ist. Im gezeigten Ausführungsbeispiel ist die reflektierende erste Elektrode 3 aus einem Metall, wobei sich hierfür insbesondere Silber eignet. Auf der organischen Schichtenfolge 1 ist weiterhin eine zweite Elektrode 4 angeordnet, die aus einem transparenten leitfähigen Oxid ist und die transparent für die Primärstrahlung ist. Die elektromagnetische Primärstrahlung, die im aktiven Bereich 10 erzeugt wird, kann somit durch die zweite Elektrode 4 abgestrahlt werden. Die organische Schichtenfolge 1 und die Elektroden 3 und 4 sind auf einem Substrat 19 aufgebracht, wobei die transparente zweite Elektrode 4 dem Substrat 19 zugewandt ist und auf diesem angeordnet ist. Das Substrat 19 ist in dem gezeigten Ausführungsbeispiel Glas.

Der aktive Bereich 10 weist eine Haupterstreckungsebene E auf, die durch eine Flächennormale N charakterisiert werden kann. Der aktive Bereich 10 weist weiterhin eine Dicke d auf und einen mittleren Abstand L von der ersten Elektrode 3.

Über dem Substrat 19 ist die Wellenlängenkonversionsschicht 2 angeordnet, die einen Wellenlängenkonversionsstoff 22 eingebettet in einem Matrixmaterial 21 gemäß den Ausführungen im allgemeinen Teil aufweist. Das Matrixmaterial 21 im gezeigten Ausführungsbeispiel ist ein Epoxidharz, dass wie das Glassubstrat 19 einen Brechungsindex von etwa 1,5 aufweist. Der Wellenlängenkonversionsstoff 22 ist im gezeigten Ausführungsbeispiel eine Mischung aus einem Nitridosilikat und YAG:Ce³⁺ und geeignet, die blaue elektromagnetische Primärstrahlung in gelbfarbige elektromagnetische Sekundärstrahlung zu konvertieren. Die Sekundärstrahlung wird dabei isotrop, also gleichmäßig in alle Richtungen abgestrahlt, wie durch die Pfeile S beispielhaft angedeutet ist.

Die Wellenlängenkonversionsschicht 2 ist flächig ausgeführt und weist eine Dicke D auf. Die Wellenlängenkonversionsschicht 2 ist parallel zur Haupterstreckungsebene E des aktiven Bereichs 1 angeordnet.

Durch den Pfeil X1 ist eine Abstrahlrichtung der elektromagnetischen Primärstrahlung parallel zur Flächennormalen N angedeutet. Die Wahrscheinlichkeit, dass Primärstrahlung, die in diese Richtung abgestrahlt wird, in der Wellenlängenkonversionsschicht 2 in Sekundärstrahlung konvertiert wird, ist proportional zur maximal durchquerbaren Strecke der Primärstrahlung in der Wellenlängenkonversionsschicht 2 und damit proportional zur Dicke D der Wellenlängenkonversionsschicht 2. Für Primärstrahlung, deren Abstrahlrichtung von der Abstrahlrichtung X1 abweicht, so zum Beispiel Primärstrahlung, die entlang der beispielhaft gezeigten Abstrahlrichtung X2 unter einem Abstrahlwinkel α zur Flächennormalen N abgestrahlt wird, steigt die maximal durchquerbare Wegstrecke durch die Wellenlängenkonversionsschicht 2 proportional zu D/cos α. Somit ist folglich auch die Konversionswahrscheinlichkeit proportional zu D/cos α. Damit ist leicht ersichtlich, dass die Wahrscheinlichkeit, dass Primärstrahlung in Sekundärstrahlung umgewandelt wird, zunimmt, je größer der Abstrahlwinkel α zur Flächennormalen N ist. Der relative Anteil der Primärstrahlung im Verhältnis zur unter dem Winkel α in die Wellenlängenkonversionsschicht 2 gesamten eingestrahlten Primärstrahlung, der die Wellenlängenkonversionsschicht 2 unter einem Abstrahlwinkel α unkonvertiert verlässt, wird somit kleiner mit steigendem Winkel α.

Durch den gestrichelten Pfeil P' ist der Effekt der reflektierenden ersten Elektrode 3 auf die Abstrahlung der Primärstrahlung im aktiven Bereich wie weiter oben ausgeführt, angedeutet. Durch die oben beschriebene Selbstbeeinflussung eines Excitons durch seine "eigene" abgestrahlte Strahlung wird die Abstrahlcharakteristik der Primärstrahlung beeinflusst. Bei der vereinfachten Darstellung ist zu beachten, dass der Pfeil P' keine Ausbreitung und Reflexion eines Lichtstrahls im klassischen Sinne darstellt. Vielmehr kann die von einem Exciton abgestrahlte Primärstrahlung in Form eines Dipolstrahlungfeldes beschrieben werden, das sich in der organischen Schichtenfolge ausbreitet und von der ersten Elektrode 3 reflektiert wird.

Figur 2 zeigt Graphen für Abstrahlcharakteristiken mit Abstrahlintensitäten I(α) der Primärstrahlung einer organischen Schichtenfolge für optoelektronische Bauelemente gemäß der vorherigen Beschreibung. Auf der horizontalen Achse ist der Abstrahlwinkel α aufgetragen, während auf der vertikalen Achse die winkelabhängige normierte Abstrahlintensität aufgetragen ist.

Die Abstrahlintensität 401 zeigt eine Abhängigkeit proportional zu 1/cos α, die bei einer Abstrahlung parallel zur Flächennormalen N durch eine Intensität I₀ charakterisiert werden kann. Gemäß der vorangegangen Ausführungen ist leicht ersichtlich, dass eine solche Abstrahlcharakteristik der oben beschriebenen winkelabhängigen Konversionswahrscheinlichkeit für die elektromagnetische Primärstrahlung entgegenwirken kann und diese zumindest teilweise kompensieren kann. Die Abstrahlintensitäten 402 und 403 sind gegenüber der Abstrahlintensität 401 um eine Intensität +Q·I₀ bzw. -Q·I₀ auf der vertikalen Achse verschoben. Durch die Graphen 402 und 403 ergibt sich ein Funktionen-Bereich, in dem gemäß der Beschreibung im allgemeinen Teil geeignete Abstrahlintensitäten I(α) von optoelektronischen Bauelementen von α = 0° bis zu einem Grenzwinkel α = β verlaufen können. Solche Funktionen für Abstrahlintensitäten können wie weiter oben ausgeführt, durch Funktionen I(α) = I₀ [1/cos α + A(α)] repräsentiert werden, wobei A(α) so gewählt ist, dass |I(α) - I₀/cos α| ≤ Q·I₀ für einen Winkelbereich 0°≤ α ≤ β gilt.

Beispielhaft hierfür sind die Primärstrahlung-Abstrahlintensitäten 411 und 412 gezeigt, für die beide derselbe Winkel β gilt, angedeutet durch die vertikale gestichelte Linie 440. Die Abstrahlintensität 411 weist bei einem Winkel αₘₐₓ, angedeutet durch die vertikale gestichelte Linie 421, eine maximale Intensität Iₘₐₓ auf. Von einem Abstrahlwinkel αₘᵢₙ an, angedeutet durch die vertikale gestrichelte Linie 431, bis zum Winkel αₘₐₓ (Linie 421) nimmt die Abstrahlintensität zu und kann in diesem Bereich durch einen monoton steigenden Funktionsverlauf charakterisiert werden. Die Abstrahlintensität 412 weist ein ebenfalls einen monoton steigenden Funktionsverlauf für Abstrahlwinkel α zwischen dem zugehörigen minimalen Winkel αₘᵢₙ (Linie 432) und dem maximalen Winkel αₘₐₓ (Linie 422) auf. Die Abstrahlintensitäten 411 und 412 sind Beispiele für eine ganze Funktionsklasse von Abstrahlintensitäten I(α), die gemäß der vorangegangenen Beschreibung geeignete Abstrahlintensitäten I(α) für die ausgeführten optoelektronischen Bauelemente sein können.

Mittels Ray-Tracing-Simulationen wurden, wie im Folgenden nun beschrieben wird, die CIE-Farbortverteilungen der abgestrahlten Überlagerung der Primärstrahlung und Sekundärstrahlung für zwei optoelektronische Bauelemente 100 gemäß der Figur 1 mit verschiedenen Abstrahlintensitäten I(α) der Primärstrahlung ermittelt. Wie im allgemeinen Teil beschrieben kann die Abstrahlintensität der simulierten optoelektronischen Bauelemente 100 durch Variationen der Reflektivität R der ersten Elektrode 3, den Brechungsindex n der organischen Schichtenfolge 1 und/oder den Abstand L zwischen dem aktiven Bereich 10 und der ersten Elektrode 3 in Verbindung mit einer geeigneten Wahl der Dicke d des aktiven Bereichs 10 erreicht werden. Zum Vergleich wurde eine herkömmliche blaue OLED mit gelb-emittierendem Lumineszenzkonverter ebenfalls simuliert. Die simulierte Strahlungsauskoppeleffizienz für die Konversion im Lumineszenzkonverter der herkömmlichen OLED betrug 0,62, der für die Konversion in der Wellenlängenkonversionsschicht 2 der optoelektronischen Bauelemente 100 0,62 für die Abstrahlcharakteristik 202 und 0,59 für die Abstrahlcharakteristik 0,59. Damit betrugen alle Strahlungsauskoppeleffizienzen etwa 0,6.

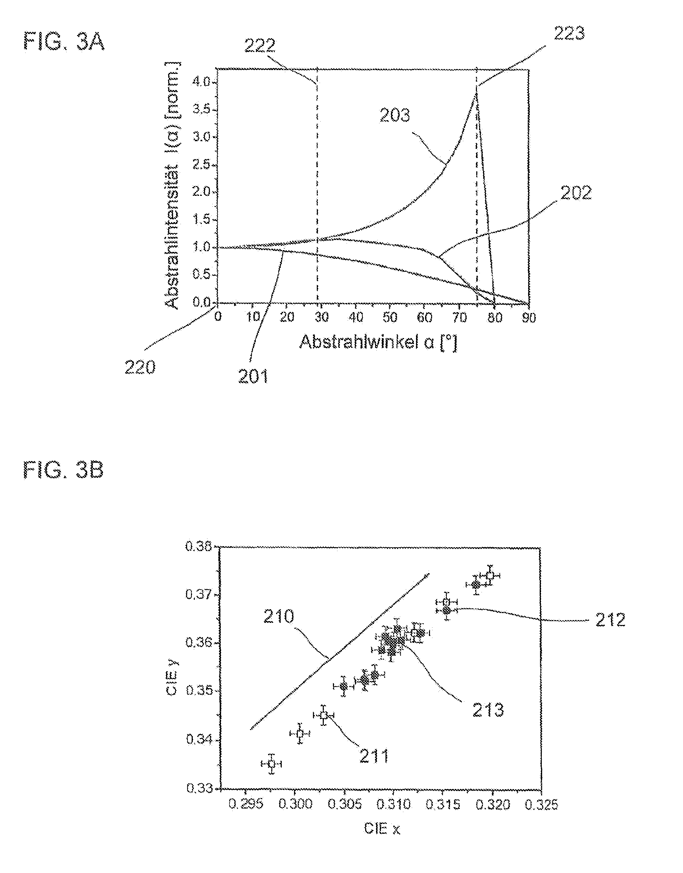

In Figur 3A sind die drei für die Simulation angenommenen Abstrahlcharakteristiken der Primärstrahlung für die herkömmliche OLED (Kurve 201) sowie die organischen Schichtenfolgen 1 von optoelektronischen Bauelementen 100 gemäß der Figur 1 (Kurven 202 und 203) gezeigt, wobei die drei Abstrahlintensitäten 201, 202, 203 auf der vertikalen Achse jeweils in Abhängigkeit vom Abstrahlwinkel α auf der horizontalen Achse aufgetragen sind.

Die Abstrahlintensität 201 der herkömmlichen OLED zeigt die typische Abstrahlcharakteristik eines Lambert'schen Strahlers, also eine Abstrahlintensität I(α) proportional zu cos α, wie für bekannte Licht emittierende Dioden typisch ist. Die Abstrahlintensität gemäß der Kurven 202 und 203 zeigen Abstrahlcharakteristiken, die von der Lambert'schen Abstrahlcharakteristik abweichen. Die Abstrahlintensitäten 202 und 203 weisen jeweils einen minimalen Winkel αₘᵢₙ = 0° (zusammenfallend mit der vertikalen Achse, angedeutet durch das Bezugszeichen 220) und einen maximalen Winkel αₘₐₓ (jeweils vertikale gestrichelte Linien 222 und 223) auf, zwischen denen die jeweilige Abstrahlintensität mit steigendem Abstrahlwinkel α bis zur maximalen Intensität Iₘₐₓ zunimmt. Der maximale Winkel αₘₐₓ für die Abstrahlintensität 202 beträgt dabei etwa 30°. Die Abstrahlcharakteristik gemäß der Kurve 203 hingegen zeigt eine Abstrahlintensität I(α) proportional zu 1/cos α bis zu einem maximalen Winkel αₘₐₓ von etwa 80°.

Die aus den Abstrahlcharakteristiken gemäß den Kurven 201, 202 und 203 resultierenden Farborte der Überlagerungen der Primärstrahlung und Sekundärstrahlung im bekannten CIE-Diagramm in Abhängigkeit vom Abstrahlwinkel α zwischen 0° und 70° wurden mittels Ray-Tracing-Simulationen ermittelt und sind in Figur 2B gezeigt. Dabei deutet der Pfeil 210 den zunehmenden Abstrahlwinkel α an. Die Punkte 211 (offene Quadrate) deuten die CIE-Farborte der von der typischen OLED mit Lumineszenzkonverter abgestrahlten elektromagnetischen Strahlung mit blauer Primärstrahlung und gelber Sekundärstrahlung mit der Abstrahlintensität 201 in Figur 2A an, die in Abhängigkeit vom Abstrahlwinkel α zwischen 0° und 70° von einem Beobachter wahrgenommen wird. Aus dem gezeigten CIE-Diagramm ist erkennbar, dass mit zunehmendem Abstrahlwinkel α eine Gelbverschiebung des Leuchteindrucks aufgrund der winkelabhängigen Konversionswahrscheinlichkeit im Lumineszenzkonverter wahrnehmbar ist. Die Punkte 212 (ausgefüllte Kreise) deuten die entsprechende CIE-Farbortvariation für die Abstrahlcharakteristik gemäß der Kurve 202 in Figur 2A für ein optoelektronisches Bauelement 100 gemäß Figur 1 an. Die Punkte 213 (ausgefüllte Quadrate) deuten dementsprechend die Farbortvariation für die Abstrahlcharakteristik gemäß der Kurve 203 in Figur 2A für ein optoelektronisches Bauelement 100 gemäß Figur 1 an. Es ist deutlich erkennbar, dass mit zunehmender Abweichung von der Lambert'schen Abstrahlcharakteristik und zunehmender Verschiebung der maximalen Abstrahlintensität Iₘₐₓ zu größen Maximalwinkeln αₘₐₓ eine Verringerung der Farbortvariation mit dem Abstrahlwinkel feststellbar ist.

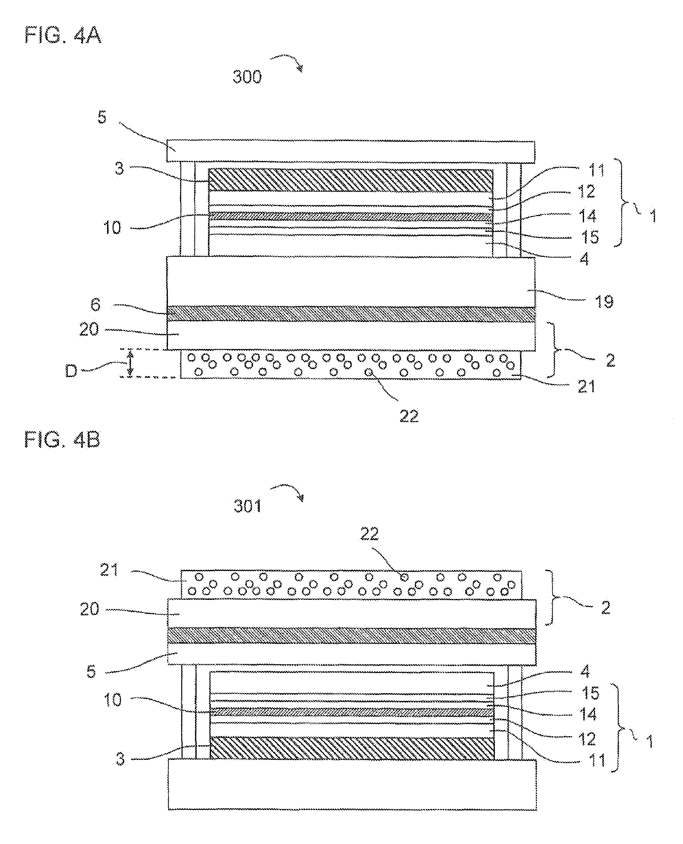

In der Figur 4A ist ein weiteres Ausführungsbeispiel für ein optoelektronisches Bauelement 300 gezeigt. Wie im Ausführungsbeispiel in Figur 1 gezeigt, weist auch das optoelektronische Bauelement 300 ein transparentes GlasSubstrat 19 auf, auf dem eine organische Schichtenfolge 1 zwischen der ersten und zweiten Elektrode 3, 4 angeordnet ist. Die Elektroden 3 und 4 sowie die organische Schichtenfolge 1 wurden mittels Standardverdampfungsprozessen aufgebracht. Die organische Schichtenfolge 1 weist insbesondere Materialien auf, die organische kleine Moleküle ("small molecules") aufweisen.

Auf dem Substrat 19 ist die transparente zweite Elektrode 4 aufgebracht. Im gezeigten Ausführungsbeispiel ist die zweite Elektrode 4 aus ITO. Auf der zweiten Elektrode 4 ist die organische Schichtenfolge 1 aufgebracht. Diese umfasst auf der zweiten Elektrode 4 eine Lochinjektionsschicht (HIL) 15 und darüber eine Elektronensperrschicht (EBL) 14. Auf dem EBL 14 ist eine elektrolumineszierende Schicht (EL) 10 aufgebracht, die den aktiven Bereich der organischen Schichtenfolge 1 bildet. Das EL 10 ist geeignet, im Betrieb des optoelektronischen Bauelements 300 blaue Primärstrahlung abzustrahlen. Über dem EL 10 sind eine Lochsperrschicht (HBL) 12 und darüber eine Elektronentransportschicht (ETL) 11 aufgebracht. Über der organischen Schichtenfolge 1 ist die erste Elektrode 3 aus Silber angeordnet, die reflektierend für die vom EL 10 abgestrahlte Primärstrahlung ist. Da das Substrat 19 und die zweite Elektrode 4 transparent sind, ist das optoelektronische Bauelement als so genannter "bottom emitter" ausgeführt.

Durch die Einbettung des EL 10 zwischen das EBL 14 und das HBL 12 kann eine gute Lokalisation und Eingrenzung des aktiven Bereichs 10 der organischen Schichtenfolge 1 erreicht werden, da Excitonen, also Elektron-Loch-Paare, nur zwischen dem EBL 14 und dem HBL 12 gebildet werden können.

Über den Elektroden 3, 4 und der organischen Schichtenfolge 1 ist eine Verkapselung 5 angeordnet, die die Elektroden 3,4 und die organische Schichtenfolge 1 vor schädlichen äußeren Einflüssen wie etwa Feuchtigkeit oder Sauerstoff oder mechanischen Beeinträchtigungen schützen kann.

Auf der der organischen Schichtenfolge 1 abgewandten Oberfläche des Substrats 19 ist im Strahlengang der Primärstrahlung der organischen Schichtenfolge 1 eine Wellenlängenkonversionsschicht 2 angeordnet. Diese weist ein Trägersubstrat 20 aus Glas auf, auf dem Nitridiosilikathaltige und YAG:Ce³⁺-haltige Wellenlängenkonversionsstoffe 22 in einem Epoxidharz-Matrixmaterial 21 aufgebracht sind. Zur Herstellung der Wellenlängenkonversionsschicht 2 wurden in einem Mahlwerk die Wellenlängenkonversionsstoffe 22 zusammen mit Epoxidharz-Materialien gleichmäßig zerkleinert und durchmischt. Die Mischung wurde auf das Substrat 20 aufgebracht und bei 150°C für 1 Stunde ausgehärtet. Die Dicke D des ausgehärteten Matrixmaterials 21 mit den Wellenlängenkonversionsstoffen 22 beträgt etwa 30 µm.

Die Wellenlängenkonversionsschicht 2 ist mittels eines optischen Gels 6 auf dem Substrat 19 aufgebracht und optisch angekoppelt.

In Figur 4B ist ein weiteres Ausführungsbeispiel für ein optoelektronisches Bauelement 301 gezeigt, das eine Variation des in Figur 4A gezeigten optoelektronischen Bauelements 300 darstellt. Beim optoelektronischen Bauelement 301 ist die erste, für die Primärstrahlung reflektierende Elektrode 3 auf dem Substrat 19 aufgebracht. Über den reflektierenden ersten Elektrode 3 ist die organische Schichtenfolge 1 wie vorher beschrieben, jedoch in umgekehrter Reihenfolge, angeordnet. Über der Schichtenfolge 1 ist die transparente zweite Elektrode 4 aus ITO angeordnet. Die Verkapselung 5 weist ebenfalls ein transparentes Material, etwa Glass oder einen transparenten Kunststoff auf. Damit kann die im EL 10 erzeugte Primärstrahlung vom Substrat 19 weggerichtet durch die zweite transparente Elektrode 4 und die Verkapselung 5 abgestrahlt werden und das optoelektronische Bauelement 301 ist damit als so genannter "top emitter" ausgeführt. Die Wellenlängenkonversionsschicht 2 ist auf der Verkapselung 5 mittels des optischen Gels 6 aufgebracht und optisch angekoppelt.

Für eine Messung der Abstrahlcharakteristiken und der CIE-Farbortverteilungen der abgestrahlten elektromagnetischen Strahlung wurden drei als OLEDs I, II und III ausgeführte optoelektronische Bauelemente gemäß dem in Figur 4A gezeigten Ausführungsbeispiel des optoelektronischen Bauelements 300 hergestellt. Alle drei optoelektronischen Bauelemente I, II und III wiesen dabei in etwa folgende Dicken der Elektroden 3, 4 und der Schichten 10, 11, 12, 14, 15 der organischen Schichtenfolge 1 auf:
- zweite Elektrode 4: 120 nm,
- HIL 15: 20 nm,
- EBL 14: 10 nm,
- EL 10: 25 nm,
- HBL 12: 10 nm,
- ETL 11: x nm,
- erste Elektrode: 150 nm.

Die Dicke x des ETL 11 betrugt für die optoelektronischen Bauelemente I, II und III in etwa 15 nm, 30 nm und 50 nm. Dadurch wird der mittlere Abstand L zwischen der reflektierenden ersten Elektrode und dem aktiven Bereich für die OLEDs I, II und III im Vergleich zueinander geändert.

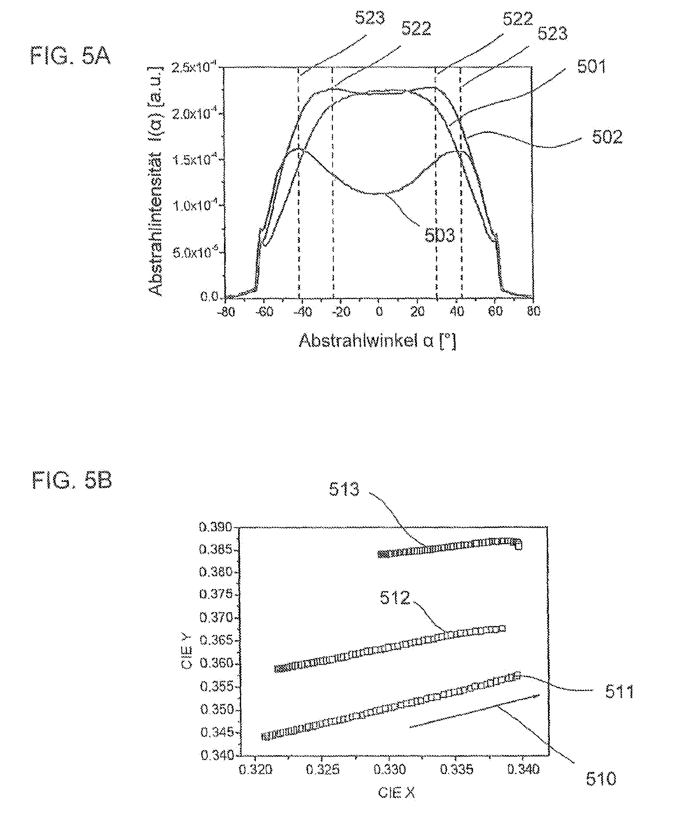

In Figur 5A sind die sich daraus ergebenden Abstrahlcharakteristiken 501, 502 und 503 als winkelabhängige Abstrahlintensitäten I(α) der Primärstrahlung gezeigt. Die Abstrahlintensität I(α) gemäß der Kurve 501 ist dabei die Abstrahlcharakteristik der OLED I mit einer ETL-Dicke x von etwa 15 nm. Die Abstrahlintensität I(α) gemäß der Kurve 502 ist die Abstrahlintensität der OLED II mit einer ETL-Dicke x von etwa 30 nm, während die Abstrahlintensität I(α) gemäß der Kurve 503 die Abstrahlintensität der OLED III mit einer ETL-Dicke x von etwa 50 nm ist.

Die OLED I mit der Abstrahlcharakteristik 501 weist dabei im Wesentlichen eine Lambert'sche Abstrahlcharakteristik auf und repräsentiert eine herkömmliche OLED. Die OLEDs II und III hingegen weisen nicht-Lambert'sche Abstrahlcharakteristiken auf, bei denen die Abstrahlintensität I(α) von einem Abstrahlwinkel α = 0° bis zu einem Maximalwinkel αₘₐₓ, repräsentiert durch die vertikalen Linien 522 und 523, hin zu einer maximalen Abstrahlintensität Iₘₐₓ ansteigt.

Die Abstrahlcharakteristiken wurden mittels folgendem Verfahren ermittelt: Anstelle der Wellenlängenkonversionsschicht 2 wurde auf dem Substrat 19 mittels eines Brechungsindex-anpassenden Gels ("index matching gel") 6 eine Glas-Halbkugel mit einem Durchmesser von 25 cm zentriert angeordnet. Mittels eines Goniometers und eines damit verbundenen Lichtleiter-Spektrometers wurde die aus der Glas-Halbkugel austretende Primärstrahlung der OLEDs I, II und III in Abhängigkeit vom Abstrahlwinkel α gemessen. Durch die Geometrie der Glas-Halbkugel war der Austrittswinkel der Primärstrahlung zur umgebenden Luft an der Halbkugel-Oberfläche derselbe wie der Abstrahlwinkel im Substrat 19. Da die Glas-Halbkugel und das Substrat 19 Brechungsindex-angepasst waren, konnte so auch Primärstrahlung gemessen werden, deren Abstrahlwinkel größer als der Winkel für Totalreflexion im Substrat 19 war. Die gemessenen Abstrahlcharakteristiken entsprechen daher den Abstrahlcharakteristiken der jeweiligen organischen Schichtenfolgen 1 der OLEDs I, II und III. Diese sind gegeben durch die Primärstrahlung, die in das Substrat 19 gelangen kann, wobei lediglich der Anteil der Primärstrahlung, der an bzw. in der zweiten Elektrode aufgrund von Totalreflexion reflektiert wird, nicht in das Substrat 19 gelangen kann.

Aus den Goniometer-Messungen konnte auch die Lichtleistung der drei OLEDs I, II und III bei einer aufgeprägten Stromdichte von 7 mA/cm² ermittelt werden. Die Lichtleistung in arbiträren Einheiten betrug 0,1074 für die OLED I, 0,1088 für die OLED II und 0,1141 für die OLED III.

In Figur 5B sind die jeweiligen CIE-Farbortverteilungen der Überlagerungen der Primärstrahlung und Sekundärstrahlung der OLEDs I (Messpunkte 511), II (Messpunkte 512) und III (Messpunkte 513), wiederum wie in Figur 3A gezeigt mit der Wellenlängenkonversionsschicht 2 ausgestattet, gezeigt. Der Pfeil 510 deutet den zunehmenden Abstrahlwinkel α an. Die Messung wurde mittels eines Standard-Goniometers durchgeführt. Man erkennt deutlich die Verringerung der Farbvariation des resultierenden Leuchteindrucks in Abhängigkeit des Abstrahlwinkels, je mehr die Abstrahlcharakteristik von der Lambert'schen Abstrahlcharakteristik gemäß Kurve 501 in Figur 5A abweicht. Die leichte Verschiebung der Farborte der OLEDs I, II und III relativ zueinander trotz der Verwendung gleicher Materialien ist dabei auf den Einfluss der durch die reflektierende erste Elektrode 3 gebildeten Mikrokavität zurückzuführen.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Optoelektronisches Bauelement, umfassend
- eine erste Elektrode (3),
- eine strahlungsemittierende Schichtenfolge (1) mit einem aktiven Bereich (10) auf der ersten Elektrode (3), der eine Haupterstreckungsebene (E) mit einer Flächennormalen (N) aufweist und eine elektromagnetische Primärstrahlung mit einer nicht-Lambert'schen Abstrahlcharakteristik emittiert,
- eine zweite für die Primärstrahlung transparente Elektrode (4) auf der strahlungsemittierenden Schichtenfolge (1), und
- eine Wellenlängenkonversionsschicht (2) im Strahlengang der Primärstrahlung, die die Primärstrahlung zumindest zum Teil in eine elektromagnetische Sekundärstrahlung konvertiert,
wobei
- die erste Elektrode (3) reflektierend für die Primärstrahlung ist,
- die nicht-Lambert'sche Abstrahlcharakteristik gegeben ist durch eine Intensität I(α) der Primärstrahlung der strahlungsemittierenden Schichtenfolge (1) in Abhängigkeit von einem zur Flächennormalen (N) gemessenen Abstrahlwinkel α,
- die Intensität I(α) von α ≥ 0° mit zunehmenden Winkel α bis zu einem Maximalwinkel αₘₐₓ hin zunimmt und
- die Konversionswahrscheinlichkeit der elektromagnetischen Primärstrahlung in der Wellenlängenkonversionsschicht (2) mit steigendem Abstrahlwinkel α zunimmt.

2. Optoelektronisches Bauelement nach dem vorherigen Anspruch, wobei
- die Abstrahlcharakteristik eine maximale Intensität Iₘₐₓ bei einem Maximalwinkel αₘₐₓ größer oder gleich 10° und kleiner oder gleich 75° aufweist.

3. Optoelektronisches Bauelement nach einem der vorherigen Ansprüche, wobei
- die Abstrahlcharakteristik für einen Winkel α = 0° eine Intensität I₀ aufweist und
- die Abstrahlcharakteristik für Winkel α mit 0° ≤ α ≤ 15° eine Intensität I(α) aufweist mit I(α) = I₀[1/cos α + A(α)] und
- A(α) Werte im Bereich -0,8 ≤ A(α) ≤ 0,8 für 0° ≤ α ≤ 15° annimmt.

4. Optoelektronisches Bauelement nach einem der vorherigen Ansprüche, wobei
- die erste Elektrode (3) ein Material mit einem Reflexionsgrad R für die elektromagnetische Primärstrahlung aufweist,
- die strahlungsemittierende Schichtenfolge (1) einen Brechungsindex n aufweist,
- der aktive Bereich (10) eine Dicke d aufweist und in einem mittleren Abstand L von der ersten Elektrode angeordnet ist, wobei der mittlere Abstand L so eingestellt ist, dass
- die organische Schichtenfolge (1) mit der ersten und zweiten Elektrode (3, 4) die nicht-Lambert'sche Abstrahlcharakteristik aufweist.

5. Optoelektronisches Bauelement nach dem vorherigen Anspruch, wobei
- der mittlere Abstand L kleiner oder gleich der halben Wellenlänge und größer oder gleich 1/20 der Wellenlänge der elektromagnetischen Primärstrahlung ist.

6. Optoelektronisches Bauelement nach Anspruch 4 oder 5, wobei
- die Dicke d des aktiven Bereichs (10) kleiner oder gleich 20 nm ist.

7. Optoelektronisches Bauelement nach einem der vorherigen Ansprüche, wobei
- die strahlungsemittierende Schichtenfolge (1) weiterhin ein Substrat (19) aufweist und
- die erste Elektrode (3) direkt auf dem Substrat (19) angeordnet ist.

8. Optoelektronisches Bauelement nach einem der Ansprüche 1 bis 6, wobei
- die strahlungsemittierende Schichtenfolge (1) weiterhin ein Substrat (19) aufweist und
- die zweite Elektrode (4) direkt auf dem Substrat (19) angeordnet ist.

9. Optoelektronisches Bauelement nach einem der vorherigen Ansprüche, wobei
- die Wellenlängenkonversionsschicht (2) einen Wellenlängenkonversionsstoff (22) auf einem transparenten Trägersubstrat (20) aufweist.

10. Optoelektronisches Bauelement nach einem der vorherigen Ansprüche, wobei
- die Wellenlängenkonversionsschicht (2) einen Wellenlängenkonversionsstoff (22) in einem transparenten Matrixmaterial (21) aufweist.

11. Optoelektronisches Bauelement nach dem vorherigen Anspruch, wobei
- das Matrixmaterial (21) Silikone, Epoxide, Acrylate, Imide, Carbonate, Olefine oder Mischungen oder Kombinationen davon aufweist.

12. Optoelektronisches Bauelement nach einem der vorherigen Ansprüche, wobei
- die Wellenlängenkonversionsschicht (2) über ein optisches Gel (6) an die strahlungsemittierende Schichtenfolge (1) optisch angekoppelt ist.

13. Optoelektronisches Bauelement nach einem der vorherigen Ansprüche, wobei
- die strahlungsemittierende Schichtenfolge (1) eine organische Schichtenfolge umfasst.

14. Optoelektronisches Bauelement nach dem vorherigen Anspruch, wobei
- der aktive Bereich (10) mindestens ein organisches Polymer, ein organisches Oligomer, ein organisches Monomer, organische kleine Moleküle oder eine Kombination daraus aufweist.

15. Optoelektronisches Bauelement nach einem der vorherigen Ansprüche, wobei
- die zweite Elektrode (4) mindestens ein transparentes Material aus einer Gruppe umfasst und die Gruppe gebildet wird durch
- ein Metall,
- ein Metalloxid, und
- ein organisches elektrisch leitendes Material.
